# EUROPEAN PATENT APPLICATION

(11) **EP 3 525 296 A1**
(43) Date of publication of application: **14.08.2019**
(21) Application number: 19155463.3
(22) Date of filing: 05.02.2019
(51) Int. Cl.: H01R 13/533, H01R 13/00, H01R 11/28

(54) **ELECTRICAL CONNECTION UNIT AND BATTERY SYSTEM**

(30) Priority: 12.02.2018 DE 102018202128
(71) Applicant: TE Connectivity Germany GmbH, 64625 Bensheim (DE)
(72) Inventor: WIENZIERS, Ronald, 64807 Dieburg (DE); WROBEL, Patrick, 64683 Einhausen (DE); HINRICHS, Holger, 68519 Viernheim (DE); GASSMANN, Gregor, 64347 Griesheim (DE); HOFFMANN, Joachim, 64653 Lorsch (DE)
(74) Representative: Grünecker Patent- und Rechtsanwälte PartG mbB

(57) **Abstract**

The present invention relates to an electrical connection unit with integrated cooling and a battery system, which has such a connection unit. In particular, the cooling can be achieved by means of a liquid coolant. An electrical connection unit (120) comprises a first electrical terminal (104) for contacting a first electrical component, a second electrical terminal (106) which is connected to an electrically conductive cable (100), wherein the electrical connection unit (120) establishes an electrical connection between the first electrical terminal (104) and the second electrical terminal (106), and a first fluidic terminal (108) for attaching a coolant source. The second electrical terminal (106), moreover, is formed as a second fluidic terminal (110), such that it connects a cooling channel (103), which is arranged on the cable (100) and through which a coolant for cooling the electrically conductive cable can flow, to the first fluidic terminal (108).

## Description

The present invention relates to an electrical connection unit with integrated cooling and to a battery system, which has such a connection unit. In particular, the cooling can be achieved by means of a liquid coolant.

All electronic components, appliances and circuits generate excess heat, and thus require thermal management in order to improve reliability and prevent premature failure. In particular, in the case of the electrical connection of a battery system in a motor vehicle, there arise, at the electrical contacts of the battery, high currents and thus considerable amounts of heat which must be dissipated as quickly and efficiently as possible, in order to avoid dangerous overheating.

There are various techniques for cooling electrical assemblies, for example air cooling using fans or thermoelectric cooling, which is based on the Peltier effect. Conventional air cooling systems with fans are limited in their capacity to dissipate heat. They are therefore suitable only to a limited extent for use with battery systems. It is substantially more efficient to discharge heat via a fluid, for example a cooling liquid such as water or an oil.

By way of example, a device for cooling a plug connection is known from DE 10 2015 221 571 A1, which device is composed of a charging plug, a contact bushing, which is suitable for receiving the charging plug, a first electrical line which is connected to the contact bushing and a second electrical line which is connected to the charging plug, wherein the first electrical line has a first cavity and/or the second electrical line has a second cavity along the electrical line, via which a coolant is conducted. For example, a tube, which surrounds the charging cable, has a coolant flow through it. This coolant can be air, oil, water or another fluid suitable for dissipating heat.

This known arrangement has the disadvantage, however, that it offers no practicable solution for cooling at the contact point to a battery.

There is therefore a requirement for means which permit a safe and efficient cooling of an electrical connection, and thus enhance and simplify the thermal management in particular directly at the contacts of a battery of an electric vehicle, both when charging the battery and when operating the vehicle.

This problem is solved by the subject-matter of the independent claims. Advantageous developments of the present invention are the subject-matter of the subclaims.

It is known to cool electrically conductive HF cables by means of a coolant liquid guided in the cable. By way of example, it is known from German examined and published application DE 1160053 B that a copper hollow tube is arranged in a tube composed of rubber, such that the copper hollow tube serves to conduct current and the rubber tube serves to conduct the coolant further, the coolant simultaneously washing around the wires of the current conductor.

The inventors of the present invention have realised that the concept of liquid cooling of an electrical line can be adapted for use in a battery system, if the electrical terminal at the battery can be configured such that it can likewise have the cooling medium flow through it, at least partly. In particular, the present invention provides an electrical connection unit which, on the one hand, can be connected to a contact of a battery, and on the other hand to a corresponding external contact.

According to the present invention, the electrical connection unit comprises a first electrical terminal for contacting a first electrical component, for example a battery, and a second electrical terminal, which is connected to an electrically conductive cable, wherein the electrical connection unit establishes an electrical connection between the first electrical terminal and the second electrical terminal. Furthermore, the electrical connection unit comprises a first fluidic terminal for attaching a coolant source. According to the present invention, the second electrical terminal, moreover, is formed as a second fluidic terminal, such that it connects a cooling channel, which is arranged on the cable and through which a coolant for cooling the electrically conductive cable can flow, to the first fluidic terminal.

In this way, it can be achieved that an electrical attachment to a heat-generating component, such as a battery for example, can be cooled efficiently. In the process, it can be ensured that the coolant can be conducted as closely as possible to the actual contact point. The connection unit thus serves to attach to both the electrical current circuit and to the coolant circuit.

In particular, if an electrically non-conductive coolant is used, electrical insulation of the electrically conductive material of the cable from the coolant can be dispensed with, as a result of which, on the one hand, the transition of heat is not impaired by an additional insulator, and on the other hand, the manufacture of the cable is simplified significantly. According to the present invention, the cable comprises an electrically conductive material, which forms a cavity which is surrounded by an insulator, wherein the cooling channel is formed in the interior of the cavity formed by the electrically conductive material.

In order to allow the greatest possible flexibility of the position of the cable in relation to the first electrical component during the mounting of the electrical connection unit, the second electrical terminal is arranged at a ring coupler, wherein the ring coupler holds the second terminal rotatably around a longitudinal axis of the first electrical terminal. The rotatability of the ring coupler can be blocked after mounting on the first electrical component, for example, by a force fit of the inventive electrical connection unit. In other words, the rotatability exists only during the mounting, while the location of the cable is fixed in the finally mounted state. If the connection between the first electrical terminal and the first electrical component is releasable, it can be provided that the rotatability is allowed again mechanically by releasing the electrical connection.

Ring support couplers for fluids are known, for example, from EP0 646 748 B1 and are used if fluid lines, which can lie in any desired angular positions in relation to each other, have to be connected to each other.

Here, the basic form of the screw is a hollow cylinder, which is closed at the head end of the screw and open at the thread end. Furthermore, at the head end, the screw has two holes lying opposite each other. The ring terminal is composed of a ring which has a hole on one side, onto which a terminal support is placed, in such a way that the support points outwards in the radial direction. The ring terminal is plugged onto the hollow screw between two sealing rings. In this configuration, a liquid can be conducted around an angle.

To attach a current line with integrated cooling system to a battery and a cooling circuit, there are, however, two requirements which cannot be fulfilled by the known solutions which focus exclusively on the fluidic connection. Firstly, it should be possible to screw the thread into the battery, and the screw should not be able to conduct liquid on the thread side, but rather current. Thus, the screw must not be hollow and open on the thread side, but rather should be solid. Secondly, it must be possible to attach a further tube, which is achieved according to the invention by means of the first fluidic terminal.

In particular for use for contacting a battery, it is advantageous for steric reasons if the electrical connection unit has a base body with a first longitudinal axis, which runs along a plugging direction of the first fluidic terminal, wherein the plugging direction of the first fluidic terminal runs along the longitudinal axis of the first electrical terminal. In this way, the battery terminal, which corresponds to the first electrical terminal, lies opposite the coolant circuit terminal, as a result of which there is a clear spatial separation between coolant circuit and battery.

According to an advantageous development of the present invention, the second electrical terminal has a second longitudinal axis, which does not run parallel to the plugging direction of the first fluidic terminal. In other words, the second longitudinal axis forms an angle not equal to 0° with the plugging direction. In this way, a releasable rapid coupler can be provided at the first fluidic terminal, for example, in order to allow a particularly simple and quick mounting of a coolant terminal, after the first electrical terminal is mounted on the contact of a battery, for example.

Furthermore, it can be provided that the ring coupler forms a coolant chamber with the base body of the connection unit. In this way, the base body is washed around in the electrical contact region by the coolant both from inside and from outside. As a result, the heat produced is discharged even better.

In particular, the first fluidic terminal can be connected fluidically to the coolant chamber of the ring coupler via at least one opening in the base body. By way of this opening, on the one hand the coolant flow is enabled, and on the other hand, however, sufficient current-carrying capacity and mechanical stability of the remaining walling of the base body is ensured. The coolant chamber is advantageously formed circulating around the base body, in such a way that the position of the at least one opening does not have to be correlated with the position of the second fluidic terminal, in order to allow an unhindered flow of coolant.

In order to allow as high a throughput of coolant as possible, it is provided that a multiplicity of openings is arranged equidistantly at a circumference of the base body.

In operation, the liquid-cooled electrical connection unit must be fluidically sealed, so that no liquid can escape. In accordance with the present invention, this is achieved advantageously by means of at least one electrically conductive sealing device. By way of example, it can be provided that at least one copper seal is fitted at the interface between the base body and the ring coupler. The advantage of such a metallic seal is that, on the one hand, the current-carrying capacity is increased, and on the other hand, that a durable and mechanically stable seal can be ensured, even under demanding environmental conditions.

According to an advantageous development of the present invention, the cable is connected to the second electrical terminal by means of a crimp connection. The advantage of such a crimp connection is that a stable mechanical and electrical connection with high current-carrying capacity can be established, even under high thermal loads. To establish the crimp connection, the second electrical terminal can have an inner sleeve and an outer sleeve, which are arranged concentrically with respect to each other and to a longitudinal axis of the second electrical terminal. The substantially tubular cable is introduced into an intermediate space between the two sleeves, and the outer sleeve is pressed onto the inner sleeve, in order to establish an electrical connection between the inner sleeve and the electrical conductor of the cable. Here, it can also be provided that the outer sleeve has inwardly directed tongues, which can penetrate the insulation of the cable in order to contact the electrical conductor. In this way, the current-carrying capacity is increased once again. Advantageously, by way of the crimp connection onto the electrically insulating sheath of the cable, the fluidic sealing also takes place between the fluid-filled cable and the second electrical terminal, which, according to the invention, also functions as a fluidic terminal.

A particularly stable and easily re-releasable electrical connection which is able to carry current and which is in particular for contacting a battery of a motor vehicle can be established, if the first electrical terminal is formed as a screw thread.

The advantages of the present invention take effect in particular if the inventive connection unit is used in a battery system of a motor vehicle, for example. Accordingly, the present invention moreover relates to a battery system having at least one electrical contact, wherein the electrical contact is connected to the first electrical terminal of a connection unit according to the present invention, and wherein the first fluidic terminal is attached to a coolant reservoir of the battery system.

Advantageously, provided that the inventive electrical connection unit has a ring coupler, this ring coupler is mechanically fixed by way of the connection between the electrical contact and the first electrical terminal. In this way, it can be achieved that the dissipation position of the cable can be adjusted according to the geometrical conditions during the mounting, and then this position is fixed securely in operation.

To better understand the present invention, it is explained in greater detail using the exemplary embodiments depicted in the following figures. Identical parts here are provided with identical reference numbers and identical component names. Furthermore, some features or combinations of features from the different embodiments shown and described may also represent solutions which are independent, inventive or in accordance with the invention per se.

In the drawings:
- **Figure 1**: shows a schematic perspective sectional view of an electrical connection unit according to an advantageous embodiment of the present invention;
- **Figure 2**: shows a lateral sectional view of the electrical connection unit from Figure 1;
- **Figure 3**: shows an unopened side view of the electrical connection unit from Figure 1;
- **Figure 4**: shows a further unopened side view of the electrical connection unit from Figure 1;
- **Figure 5**: shows an unopened perspective view of the electrical connection unit from Figure 1;
- **Figure 6**: shows a plan view of the electrical connection unit from Figure 1.

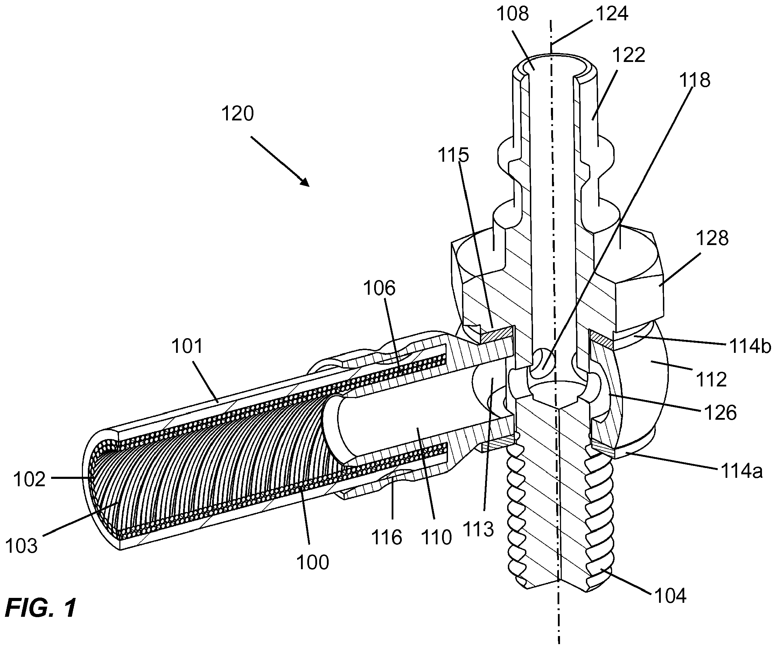

The present invention is explained in greater detail hereinbelow with reference to the figures, and firstly with reference to Figure 1.

Figure 1 shows an electrical connection unit 120, which is suitable for electrically contacting a battery contact (not shown in the figures). For this purpose, the electrical connection unit 120 has a first electrical terminal 104, which is formed as a screw connection in the embodiment shown. For a person skilled in the art, however, it is clear that other configurations of the first electrical terminal, such as plug connectors or press-in connections for example, can also be used.

The first electrical terminal 104 is part of a base body 122, which extends along a first longitudinal axis 124. The base body 122 is partly hollow and has a first fluidic terminal 108 for attaching a coolant line (not shown in the figures). In the embodiment shown, the first fluidic terminal 108 is configured as a rapid coupler. In this way, the electrical connection unit 120 can be attached quickly and releasably, for example, to the vehicle-internal cooling circuit of a battery.

In accordance with the present invention, a second electrical terminal 106 is provided on the electrical connection unit 120, said terminal being connected to a cable 100 and providing both the electrical contacting to the electrically conductive material 102 of the cable as well as the fluidic contacting. According to the invention, the cable 100 has an electrically insulating sheath 101, in the interior of which an electrically conductive material 102 is arranged. In this way, the cable forms a cooling channel 103 in its interior, through which coolant can flow. According to an advantageous embodiment, the cable 100 comprises a Teflon tube 101 on the outside and a metal mesh 102 on the inside. In order to achieve optimum conductivity, copper is used as the metal. The conductivity of this construction can be increased, by using several layers of the copper mesh. In order to cool this conductor, a coolant is conducted through the cavity formed by the copper mesh 102. By way of the fabric structure, a very large interface can be achieved between the copper and the coolant, as a result of which efficient cooling is made possible.

In accordance with the present invention, the second fluidic terminal 110 is arranged on a ring coupler 112, so that said terminal can rotate around the axis 124. This arrangement allows a significantly facilitated mounting of the electrical connection unit 120 according to the invention.

It is of course clear, however, to a person skilled in the art that the combined second electrical and fluidic terminal 106, 110 can also be formed integrally on the base body 122.

The base body 122 has openings 118, which are arranged equidistantly around its circumference in order to allow coolant to flow into the coolant chamber 113 formed by the ring coupler. Here, the coolant flow is directed in a fluidically advantageous manner, in such a way that it runs from the first fluidic terminal 108 through the openings 118 to the second fluidic terminal 110, and enters into the electrically conductive cooling channel 103 of the cable 100. Of course, this direction of flow is not obligatory, however.

The arrangement according to the invention makes it possible for both the cable 100 and also the immediate environment of the conductors 104, 106 through which current flows to be able to be cooled by means of a coolant. As a result, heat produced can be discharged significantly better than in the case of known arrangements, and dangerous overheating can be avoided.

In the embodiment shown, the interfaces 115 between the base body 122 and the ring coupler 112 are sealed by two copper rings 114. In the non-mounted state, the support of the ring coupler 112, which forms the second electrical terminal 106 and the second fluidic terminal 110, can still rotate around the longitudinal axis 124 and the compactions 114 still have no sealing function. As soon as the screw connection of the first electrical terminal 104, however, is mounted with sufficient firmness on a mating contact carrier (not shown in the figures), the first copper seal 114a lies on a counter bearing not depicted in the figures.

By way of the forces acting in the axial direction along the longitudinal axis 124, the copper seals 114 are pressed against the ring coupler 112. Consequently, on the one hand the ring coupler 112 can no longer rotate around the longitudinal axis 124. On the other hand, the interfaces 115 with the base body 122 are sealed in a liquid-tight manner. In order to facilitate the mounting of the inventive electrical connection unit 120, an actuation unit 128 similar to a screw nut is arranged on the base body 122. Thus, the electrical connection unit 120 can be mounted using conventional mounting tools, for example on a battery. Provided that the first fluidic terminal is still open, the actuation unit 128 is easily accessible for a tool and the base body 122 can be screwed securely, without the support 111, which forms the second electrical and fluidic terminal 106, 110, rotating with it. Only shortly before the final mounting position is reached does the ring coupler 112 become jammed and no longer able to be rotated.

Advantageously, the cable 100 can thus already be mounted on the second electrical terminal 106 in the factory.

According to the embodiment shown, the support 111 is equipped with an inner sleeve 130 and an outer sleeve 132 for this purpose. In the radial direction, a circumferential gap is formed between the inner sleeve 130 and the outer sleeve 132, into which gap the cable 100 is inserted.

In a crimp region 116, the outer sleeve 132 is pressed radially inwards in the direction of the cable 100 and the inner sleeve 130. As a result, the electrically conductive material 102 of the cable 100 is pressed onto the outside of the inner sleeve 130, such that an electrical contacting takes place. Moreover, the crimp region 116 also forms a radially circumferential press-fit connection between the outer sleeve 132 and the electrically insulating sheath 101 of the cable 100. Thus, in a particularly simple manner, the mechanical fixing of the cable 100 and a fluidic seal between the support 111 and the fluid channel 103 are established.

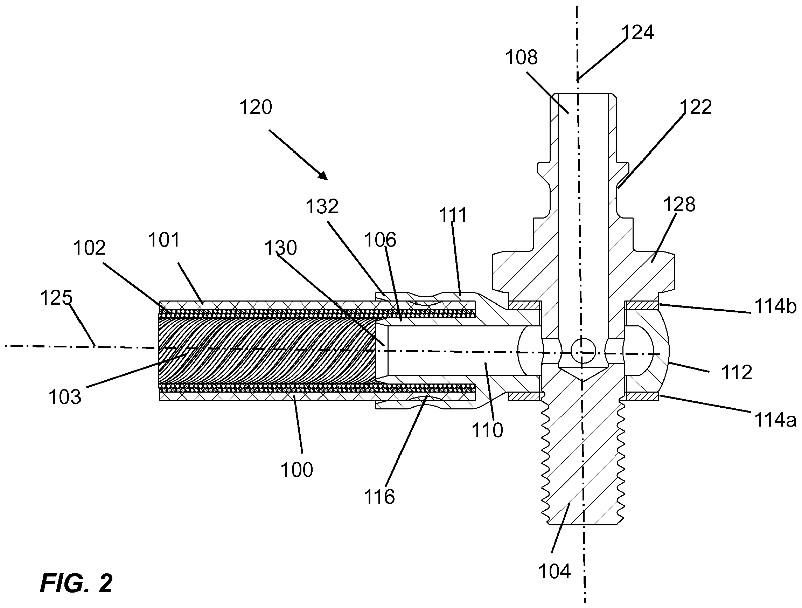

Figure 2 shows the arrangement from Figure 1 in a sectional lateral view. As can be seen from this depiction, the coolant chamber 113 has a rounded inner surface 126 which runs torically around the outer walling of the base body 122 and which makes it possible to conduct cooling liquid, which flows through the openings 118, in an annular manner around the base body 122 into the second fluidic terminal 110. A longitudinal axis 125 of the support 111 runs, according to the invention, not parallel to the first longitudinal axis 124, such that a space-saving yet flexible angled connector arrangement is produced.

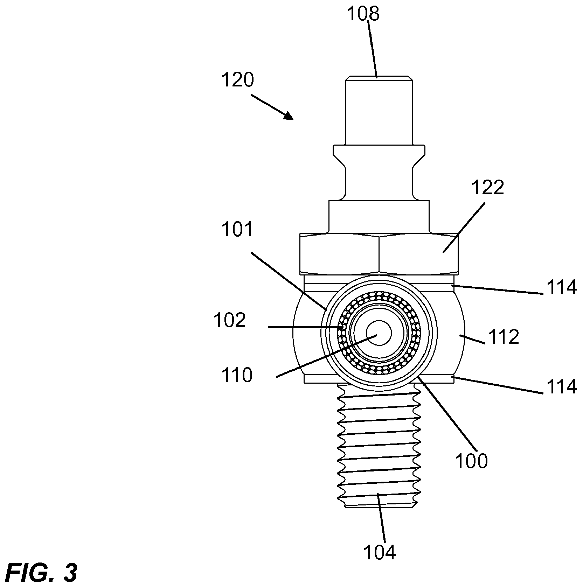

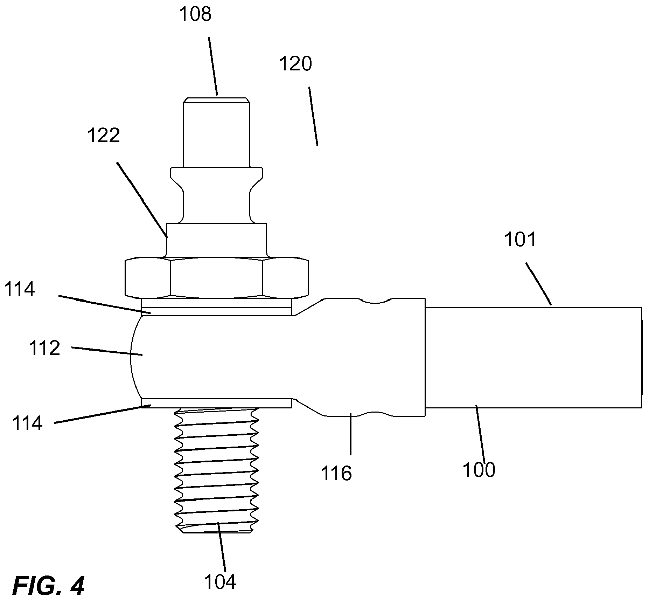

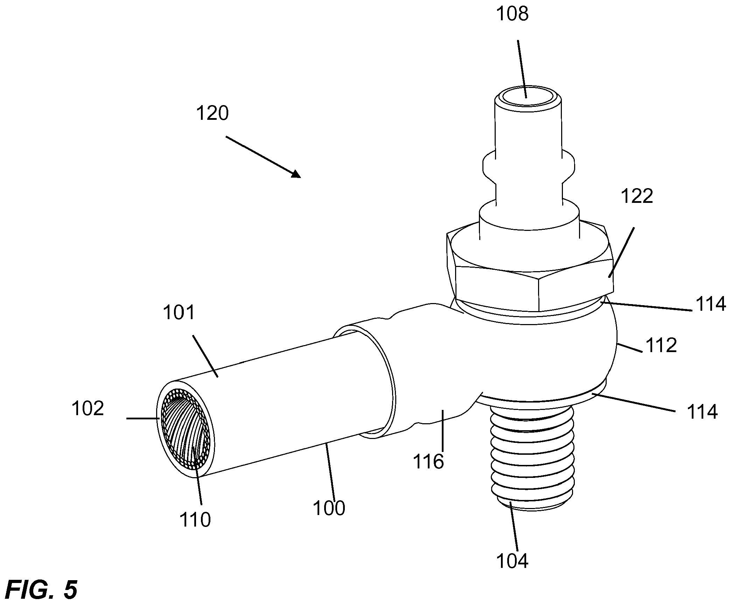

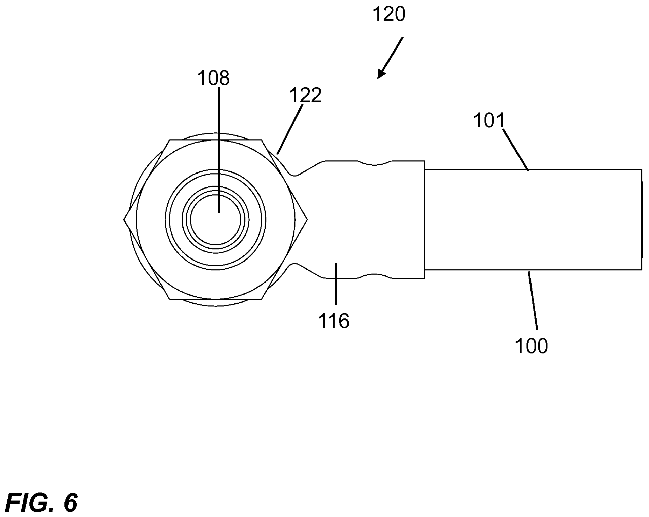

Figures 3 to 6 illustrate the electrical connection unit 120 according to the embodiment shown in Fig. 1, in various further views.

**List of reference symbols:**

| **Reference number** | **Description** |
|---|---|
| 100 | cable |
| 101 | insulator |
| 102 | electrically conductive material; metal mesh |
| 103 | cooling channel |
| 104 | first electrical terminal |
| 106 | second electrical terminal |
| 108 | first fluidic terminal |
| 110 | second fluidic terminal |
| 111 | support |
| 112 | ring coupler |
| 113 | coolant chamber |
| 114; 114a, 114b | sealing device; copper rings |
| 115 | interface |
| 116 | crimp region |
| 118 | opening |
| 120 | electrical connection unit |
| 122 | base body |
| 124 | first longitudinal axis |
| 125 | second longitudinal axis |
| 126 | inner surface |
| 128 | actuation unit |
| 130 | inner sleeve |
| 132 | outer sleeve |

## Claims

1. An electrical connection unit, comprising
a first electrical terminal (104) for contacting a first electrical component,
a second electrical terminal (106), which is connected to an electrically conductive cable (100), wherein the electrical connection unit (120) establishes an electrical connection between the first electrical terminal (104) and the second electrical terminal (106), and
a first fluidic terminal (108) for attaching a coolant source,
wherein the second electrical terminal (106), moreover, is formed as a second fluidic terminal (110), such that it connects a cooling channel (103), which is arranged on the cable (100) and through which a coolant for cooling the electrically conductive cable can flow, to the first fluidic terminal (108).

2. The electrical connection unit according to Claim 1, wherein the cable (100) comprises an electrically conductive material (102), which forms a cavity which is surrounded by an insulator (101), wherein the cooling channel (103) is formed in the interior of the cavity formed by the electrically conductive material (102).

3. The electrical connection unit according to any one of Claims 1 or 2, wherein the second electrical terminal (106) is arranged at a ring coupler (112) and wherein the ring coupler (112) holds the second terminal (106) rotatably around a longitudinal axis of the first electrical terminal (104).

4. The electrical connection unit according to Claim 3, wherein the connection unit (120) has a base body (122) with a first longitudinal axis, which runs along a plugging direction of the first fluidic terminal (108), and wherein the plugging direction of the first fluidic terminal (108) runs along the longitudinal axis of the first electrical terminal (104).

5. The electrical connection unit according to Claim 4, wherein the second electrical terminal (106) has a second longitudinal axis, which does not run parallel to the plugging direction of the first fluidic terminal (108).

6. The electrical connection unit according to any one of Claims 3 to 5, wherein the ring coupler (112) forms a coolant chamber (113) with the base body (122) of the connection unit (120).

7. The electrical connection unit according to Claim 6, wherein the first fluidic terminal (108) is fluidically connected to the coolant chamber (113) of the ring coupler (112) via at least one opening (118) in the base body (122).

8. The electrical connection unit according to Claim 7, wherein a multiplicity of openings (118) is arranged equidistantly at a circumference of the base body (122).

9. The electrical connection unit according to any one of Claims 3 to 8, wherein an interface between the base body (122) and the ring coupler (112) can be sealed by means of at least one electrically conductive sealing device (114).

10. The electrical connection unit according to Claim 9, wherein the at least one electrically conductive sealing device (114) comprises a copper ring.

11. The electrical connection unit according to any one of Claims 1 to 10, wherein the cable (100) is connected to the second electrical terminal (106) by means of a crimp connection (116).

12. The electrical connection unit according to Claim 11, wherein the cable (100) has an insulating sheath (101)for electrically insulating the cable (100) and for fluidically sealing at the crimp connection (116).

13. The electrical connection unit according to any one of the preceding claims, wherein the first electrical terminal (104) is formed as a screw thread.

14. A battery system having at least one electrical contact, wherein the electrical contact is connected to the first electrical terminal (104) of a connection unit (120) according to any one of the preceding claims, and wherein the first fluidic terminal (108) is attached to a coolant reservoir of the battery system.

15. The battery system according to Claims 3 and 14, wherein the ring coupler (112) is mechanically fixed by way of the connection between the electrical contact and the first electrical terminal (104).
